# FASCICULE DE BREVET EUROPEEN

(11) **EP 1 133 582 B1**
(45) Date de publication et mention de la délivrance du brevet: **24.03.2004**
(21) Numéro de dépôt: 99947578.3
(22) Date de dépôt: 14.10.1999
(51) Int. Cl.: C23C 16/44, C23C 16/34, C23C 16/36

(54) **PROCEDE DE PREPARATION DE REVETEMENTS A BASE DE TITANE**
VERFAHREN ZUR HERSTELLUNG VON BESCHICHTUNGEN AUF TITANBASIS
METHOD FOR PREPARING TITANIUM COATINGS

(30) Priorité: 15.10.1998 FR 9812952
(43) Date de publication de la demande: 19.09.2001
(73) Titulaire: COMMISSARIAT A L'ENERGIE ATOMIQUE, 75752 Paris Cédex 15 (FR)
(72) Inventeur: ANDERBOUHR, Stéphanie, F-38000 Grenoble (FR); SCHUSTER, Frédéric, Les Ombelles 38250 Lans-En-Vercors (FR); FILHOL, Lionel, Impasse des Pensées 38160 Saint-Sauveur (FR)
(74) Mandataire: Audier, Philippe André
(86) Numéro de dépôt international: PCT/FR1999/002498
(87) Numéro de publication internationale: WO 2000/022187

(56) Documents cités:
- EP-A- 0 530 779
- WO-A-90/11858
- DE-A- 4 408 250
- DE-A- 19 530 518
- PATENT ABSTRACTS OF JAPAN vol. 004, no. 073 (C-012), 28 mai 1980 (1980-05-28) & JP 55 038936 A (HONDA MOTOR CO LTD), 18 mars 1980 (1980-03-18)
- LEE S -H ET AL: "(TI1-XALX)N COATINGS BY PLASMA-ENHANCED CHEMICAL VAPOR DEPOSITION" JOURNAL OF VACUUM SCIENCE AND TECHNOLOGY: PART A, vol. 12, no. 4, 1 juillet 1994 (1994-07-01), pages 1602-1607, XP000608885 cité dans la demande
- PATENT ABSTRACTS OF JAPAN vol. 097, no. 009, 30 septembre 1997 (1997-09-30) & JP 09 125249 A (HITACHI TOOL ENG LTD), 13 mai 1997 (1997-05-13)

## Description

La présente invention concerne un procédé selon la revendication 1 de préparation par dépôt chimique en phase vapeur assisté par plasma (encore appelé PACVD ou "Plasma Assisted Chemical Vapour Deposition" en anglais) de revêtements à base de titane, et éventuellement d'un autre métal de préférence l'aluminium, tels que des revêtements de carbures, nitrures ou carbonitrures.

Plus précisément, l'invention est relative à un procédé de préparation d'un revêtement comprenant au moins une couche choisie parmi les couches constituées de nitrure de titane TiN, les couches constituées de carbonitrure de titane TiCN, les couches constituées de nitrure de titane et d'un autre métal M (Ti, M)N ou Ti₁₋ₓMₓN et les couches constituées de carbonitrure de titane et d'un autre métal M (Ti,M)NC ou Ti₁₋ₓMₓNC, M étant en particulier l'aluminium.

Le domaine technique de l'invention peut être généralement défini comme celui du dépôt de couches minces sur des substrats en vue d'améliorer les propriétés de ces derniers notamment les propriétés mécaniques.

Les céramiques de type carbure, nitrure ou carbonitrure ont trouvé depuis longtemps de nombres applications industrielles en particulier du fait de leurs excellentes résistances à la corrosion et à l'usure.

Parmi les céramiques de type nitrure, le nitrure de titane (TiN) est particulièrement intéressant du fait de ses caractéristiques mécaniques attractives, à savoir un faible coefficient de frottement, une bonne résistance à l'usure, et une dureté élevée, représentée par une dureté Knoop ("Hardness Knoop" en anglais) d'environ 1400.

Le nitrure de titane est donc utilisé depuis longtemps pour le revêtement en surface, sur quelques micromètres d'épaisseur, de substrats, en particulier d'outils de coupe, notamment d'outils de coupe en acier opérant à grande vitesse, afin d'augmenter leur résistance à l'usure.

Toutefois, les dépôts de nitrure de titane présentent l'inconvénient majeur de s'oxyder, par exemple à l'air ambiant, à partir de 773 K, ce qui exclut l'utilisation de tels dépôts à haute température. On a donc cherché à mettre au point d'autres revêtements permettant de remédier à ces inconvénients et susceptibles de répondre de manière spécifique à chaque application particulière.

Ainsi, de nombreuses recherches se sont portées sur des nitrures de titane plus complexes.

Il est ainsi apparu que l'ajout d'un ou de plusieurs éléments supplémentaires tels que le carbone, l'aluminium, le hafnium, le zirconium, le vanadium, le niobium, etc. permettait d'élargir le champ d'application des composés du type nitrure de titane et d'apporter en conséquence de nouvelles solutions dans des domaines bien spécifiques tels que la résistance à l'usure, la résistance à l'oxydation, l'amélioration des propriétés de surface et de l'aspect du substrat.

On peut citer par exemple les dépôts de nitrure de titane-zirconium ou de nitrure de titane-hafnium proposés pour certaines applications ou encore le revêtement métastable Ti-Al-C-N qui combine certaines propriétés intéressantes des phases ternaires (Ti,Al)N et Ti(C,N), à savoir une très bonne résistance à l'usure, un coefficient de frottement bas et une grande stabilité thermique ainsi qu'une dureté élevée, même à haute température.

Un autre exemple plus connu de ce type de revêtement est le revêtement de nitrure de titane aluminium.

Il s'est en effet avéré que l'insertion d'aluminium dans le réseau cubique du nitrure de titane TiN amenait un accroissement sensible de la résistance à l'oxydation et de la dureté du dépôt. En effet, il se formerait à la surface du nitrure de titane aluminium encore dénommé (Ti,Al)N ou Ti₁₋ₓAlₓN, une couche mince protectrice d'alumine amorphe qui préserverait le revêtement dur de toute oxydation supplémentaire.

En revanche, il a été mis en évidence qu'un tel phénomène n'est pas observé lors de dépôts mixtes des composés stables de TiN et d'AlN. De par ses excellentes propriétés, le nitrure de titane-aluminium est tout d'abord un matériau privilégié dans la protection mécanique et thermique des outils de coupe et a donc été proposé pour l'usinage à fort échauffement, en outre, le nitrure de titane-aluminium présente une excellente résistance chimique aux atmosphères corrosives et aux métaux fondus tels que les bains d'aluminium liquide.

Pour ce qui concerne les procédés d'élaboration, les procédés utilisés pour les dépôts de couches ou revêtements de TiN et de (Ti,AI)N ou Ti₁₋ₓAlₓN, sont essentiellement des procédés de dépôt physique en phase vapeur (PVD ou "Physical Vapour Deposition" en anglais) tels que la pulvérisation magnétron réactive, le dépôt ionique ou l'évaporation cathodique par arc.

La technique de dépôt physique en phase vapeur PVD est particulièrement bien adaptée au dépôt du nitrure de titane, sur des substrats tels que des outils en acier, car la température de traitement ne doit pas excéder 750°C, température au-dessus de laquelle se produit généralement la transformation de phase de l'acier.

Les procédés PVD présentent certains inconvénients, liés essentiellement à la difficulté de revêtir uniformément des substrats et des pièces de formes complexes et/ou de grandes dimensions et à la complexité de mise en oeuvre de la préparation des cibles de PVD.

On a donc cherché à préparer des couches et revêtements de TiN, et de (Ti,Al)N ou Ti₁₋ₓAlₓN par des procédés de dépôt chimique en phase vapeur (CVD ou "Chemical Vapour Deposition" en anglais), ces procédés présentent notamment l'avantage d'être non-directifs, de permettre le revêtement uniforme de pièces de formes complexes tels que des outils de coupe, et/ou de grandes dimensions par exemple plusieurs mètres, et d'assurer un meilleur contrôle de la stoechiométrie des couches.

Pour les dépôts sur certains substrats tels que les aciers, il existe cependant des contraintes drastiques de température afin d'éviter toute modification des propriétés de ce substrat comme on l'a déjà indiqué ci-dessus. Les procédés de CVD thermique qui utilisent de manière classique TiCl₄, AlCl₃, N₂ et H₂ sont donc affectés d'un inconvénient rédhibitoire, car la décomposition des halogénures précurseurs se produit à des températures supérieures à 850°C.

On a donc cherché à développer des procédés de dépôt chimique en phase vapeur (CVD) autres que le procédé dit de CVD thermique qui permettent de réduire les températures de dépôt.

Une autre technique de dépôt chimique en phase vapeur (CVD) de films de nitrure de titane de (Ti,Al)N est donc la technique dite de dépôt chimique en phase vapeur de composés organométalliques réalisée généralement à basse pression, qui est dénommée OMCVD ("Organo Metallic Chemical Vapour Deposition" en anglais) ou MOCVD ("Metallo Organic CVD" en anglais), ou encore LPOMCVD ("Low-Pressure Organo Metallic Chemical Vapour Deposition" en anglais).

L'utilisation de précurseurs organo-métalliques au lieu des précurseurs de type chlorures métalliques utilisés dans les procédés de dépôt chimique en phase vapeur classiques, dit procédés de CVD "thermique" permet de réduire notamment la température de réaction, qui passe par exemple de 873 K avec les chlorures, à 673 K et même à 473 K avec des composés organométalliques.

Ainsi, le document de C. JIMENEZ, S. GILLES, C. BERNARD et R. MADAR "Deposition of TiN Thin Films by Organometallic Chemical Vapour Déposition : Thermodynamical Predictions and Experimental Results", Surface and Coatings Technology, 76-77 (1995) 237-243, décrit-il le dépôt à basse pression de films de nitrure de titane pur à partir de tetrakis-diméthylamino-titane (Ti(N(CH₃)₂)₄) en tant que précurseur et de NH₃.

A l'instar des couches et revêtements de TiN, des revêtements de (Ti,Al)N ou Ti₁₋ₓAlₓN ont également été préparés par OMCVD. Ainsi, le document de S. GILLES, N. BOURHILA, S. IKEDA, C. BERNARD et R. MADAR ICMCTF, mai 1997, Conference ICMCTF, San Diego, décrit-il le dépôt de monocouches minces de nitrure de titane d'aluminium (Ti,Al)N ou Ti₁₋ₓAlₓN par dépôt chimique en phase vapeur utilisant des précurseurs organométalliques (OMCVD) à partir d'un gaz contenant de l'ammoniac et en tant que précurseurs métalliques du tétrakis-diméthylaminotitane Ti(N(CH₃)₂)₄ et de l'hexakis-diméthylaminodialuminium Al₂(N(CH₃)₂)₆.

Les procédés de dépôt par CVD mettant en jeu des précurseurs organo-métalliques présentent cependant un certain nombre d'inconvénients : en effet, du fait de leur réactivité, ces composés sont souvent très instables et ont tendance à se décomposer de plus les sources organo-métalliques restent chères, peu disponibles, difficiles et dangereuses à manipuler et sont souvent à l'origine d'une contamination finale importante du film déposé.

Une autre technique qui constitue une caractéristique de la technique de CVD thermique et qui permet d'opérer à plus faible température est la technique dite de dépôt chimique en phase vapeur à basse pression (LPCVD ou "Low Pressure Chemical Vapour Deposition" en anglais) qui est décrite par exemple dans le document S. ANDERBOUHR, E. BLANQUET, V. GHETTA, C. BERNARD, Electroch. Soc. Proc. of the 14th Conf. EUROCVD XI, 25 (1997) 356.

Dans ce document, des films de TiN et de Ti₁₋ₓAlₓN sont déposés à des températures de 873 à 1073 K à partir de précurseurs qui sont des chlorures d'aluminium et de titane produits par chloruration in situ de titane ou d'un alliage de titane et d'aluminium ainsi que de l'ammoniac. Les précurseurs sont dilués dans un courant gazeux d'hydrogène et d'argon. La chloruration est réalisée par balayage de la charge de Ti ou d'alliage TiAl au moyen de chlore gazeux Cl₂ à 1023 K.

Les précurseurs formés sont essentiellement l'AlCl₃ et le TiCl₄, mais aussi les sous-chlorures de titane et d'aluminium tels que le TiCl₃ et les AlClₓ (avec x=1,2) qui ont une température de décomposition plus basse que les chlorures directs.

Des couches de TiN et de (Ti,Al)N ou Ti₁₋ₓAlₓN ont également été déposées par la technique de dépôt chimique en phase vapeur assisté par plasma PACVD ou PECVD ("Plasma Assisted (ou Enhanced) Chemical Vapour Deposition" en anglais), qui permet également un traitement à température relativement faible.

Ainsi, le document de S.H. LEE, H.J. RYOO et J.J. LEE, J. Vac. Sci. Technol. A12(4) (1994), 1602 est-il relatif à la préparation sur de l'acier de revêtements monocouches de Ti₁₋ₓAlₓN de composition fixe par la technique de PECVD-PACVD en utilisant un mélange gazeux de TiCl₄, d'AlCl₃, de NH₃, d'hydrogène et d'argon. Dans ce document, les précurseurs chlorures sont fournis tels quels et sont simplement évaporés et non préparés par chloruration d'une charge métallique.

Le document de K.H. KIM et S.H. LEE, Thin Solid Films, 283 (1996), 165-170 décrit la préparation de revêtements monocouches de Ti₁₋ₓAlₓN de composition fixe sur des substrats en acier et en silicium par la technique PACVD en utilisant un mélange gazeux analogue à celui du document précédent mais dans lequel l'ammoniac est remplacé par de l'azote.

Dans ce document, les précurseurs TiCl₄ et AlCl₃ sont fournis tels quels et simplement évaporés, et ne sont pas obtenus par chloruration d'une charge.

Le document de S.H. LEE, K.H. KIM, J. Mat. Sc. Lett., 14 (1995), 1531 concerne la préparation de revêtements de Ti₁₋ₓAlₓN par la technique de PACVD en utilisant un mélange gazeux de TiCl₄, d'AlCl₃, de N₂, de H₂ et d'argon. Les précurseurs, comme dans les documents précédents, sont fournis tels quels et ne sont pas préparés par chloruration d'une charge.

Enfin, le document de A. LEONHARDT, K. BARTSCH, U. LANGER, K. KUNANZ, Surf. Coat. Technol. 94-95, (1997)168 décrit la préparation de couches dures de (Ti,Al)N mais aussi de TiC/C et de (Ti,Al)C sur de l'acier par le procédé PACVD à partir d'un mélange gazeux composé de H₂, N₂, Ar, TiCl₄, CH₄ et AlCl₃, ce dernier étant formé par réaction de HCl avec une charge d'aluminium métallique.

Les procédés décrits dans les documents mentionnés ci-dessus se distinguent par le type de décharge mise en oeuvre, on distingue ainsi essentiellement d'une part les décharges alternatives de type radiofréquence en gamme haute fréquence (de l'ordre de 13,56 Mz), le procédé est alors appelé r.f. PACVD (ou "radio-frequency PACVD" en anglais), et d'autre part les décharges avec une assistance plasma en courant pulsé, le procédé est alors appelé "pulsed d.C. PACVD (ou "pulsed direct current PACVD" en anglais). A la première catégorie appartiennent les procédés décrits dans les documents de LEE et al. et KIM et al. précités, et à la seconde catégorie appartient le procédé décrit dans le document de LEONHARDT et al. précité.

Dans les procédés de dépôt chimique en phase vapeur (CVD) et plus particulièrement de dépôt chimique en phase vapeur (PACVD) décrits ci-dessus, les précurseurs utilisés pour former le dépôt par réaction notamment en milieu plasmagène sont essentiellement des chlorures métalliques tels que des chlorures de titane et d'aluminium qui sont formés par chloruration d'une charge métallique.

Pour la chloruration de la charge, le composé chloré utilisé est généralement du dichlore gazeux : Cl_{2(gazeux)} ou bien encore de l'acide chlorhydrique : HCl_{(liquide)} qui posent de nombreux problèmes liés à leur toxicité et à leur caractère corrosif entraînant la corrosion perforante des pièces métalliques mises en oeuvre dans, et au voisinage du dispositif de dépôt, par exemple de l'enceinte de dépôt, du substrat et de la tuyauterie.

D'autre part, d'autres problèmes sont liés à la nature même de la charge métallique utilisée. En effet, les charges sont généralement des charges d'alliage, par exemple d'alliage TiAl, dont le prix est élevé et l'approvisionnement aléatoire. De plus, les charges d'alliages, comme le TiAl, élaborées industriellement comprennent des éléments additifs tels que le chrome, le niobium, le vanadium susceptibles d'entraîner ensuite une contamination du dépôt et un défaut de maîtrise de sa composition.

Par ailleurs, aucun des documents cités ci-dessus relatifs aux techniques CVD ne mentionne ni n'évoque la préparation de revêtements formés d'un empilement multicouche par exemple de TiN et/ou de nitrure de titane et d'un autre métal tel que (Ti,Al)N et/ou de carbonitrure de titane et/ou de carbonitrure de titane et d'un autre métal.

Il est cependant connu que des revêtements multicouches comprenant un empilement de couches de TiN et/ou de (Ti,Al)N peuvent être réalisés mais uniquement par la technique de dépôt physique en phase vapeur (PVD).

C'est notamment le cas du revêtement multicouche anti-usure commercialisé sous la dénomination "BALINIT FUTURA" par la société BALZERS®, dont l'application principale reste le domaine de l'outillage.

Outre les défauts déjà indiqués plus haut dans le cas du dépôt de revêtements à une seule couche, et inhérents au procédé de dépôt physique en phase vapeur (PVD), la mise en oeuvre de ce procédé PVD pour la préparation d'un revêtement multicouche présente de plus l'inconvénient d'une grande rigidité, puisque les cibles de PVD ont une composition fixée.

En revenant au cas de revêtements ne comportant qu'une seule couche et de manière similaire, si l'on souhaite déposer sur différents substrats des revêtement monocouche de composition différente, cela impose chaque fois le changement de la cible et/ou le déplacement vers une autre enceinte de dépôt.

Le dépôt par PVD ne peut permettre par exemple que le dépôt d'un revêtement ayant une alternance de couches de TiN et de (Ti,Al)N, les couches de (Ti,Al)N ayant chaque fois la même composition, c'est-à-dire la même proportion en aluminium, il n'est pas en effet pas possible de faire varier la proportion en aluminium d'une couche en (Al,Ti)N à l'autre car cela entraînerait chaque fois la préparation et l'installation d'une cible différente.

Du fait du peu de souplesse et de flexibilité d'un tel procédé, les applications demeurent très limitées car une installation ne peut servir que dans le cadre du dépôt d'un revêtement bien précis et nécessite de longues et coûteuses opérations d'adaptation et de modification pour pouvoir être utilisé pour le dépôt d'un autre revêtement qui diffère par la nature et/ou la composition d'une couche.

Il existe donc un besoin non encore satisfait pour un procédé de préparation d'un revêtement par dépôt chimique en phase vapeur assisté par plasma qui présente tous les avantages inhérents à ce type de technique, à savoir essentiellement sa température de dépôt réduite permettant le dépôt sur tous types de substrats tels que l'acier, mais qui ne présente pas les différents problèmes liés aux charges en alliage et aux composés de chloruration toxiques et corrosifs mis en oeuvre dans ces procédés.

Il existe en outre un besoin non encore satisfait pour un procédé de préparation d'un revêtement, en particulier d'un revêtement multicouche comprenant un empilement de plusieurs couches choisies par exemple parmi les couches constituées de TiN et de Ti₁₋ₓAlₓN, qui soit, entre autres, facile à mettre en oeuvre, nécessite un nombre réduit d'opérations, qui soit d'une grande souplesse d'utilisation, qui permette de préparer avec des opérations d'adaptation réduites, une grande variété de revêtements différant par la nature et/ou le nombre, et/ou la composition, et/ou la succession des couches déposées et enfin qui donne des revêtements présentant d'excellentes propriétés mécaniques et de résistance à la corrosion, et ayant des compositions parfaitement définies.

Enfin, ce procédé doit également permettre un revêtement uniforme, d'épaisseur maîtrisée quelle que soit la géométrie du substrat.

Le but de l'invention est donc de fournir un procédé de préparation d'un revêtement sur un substrat comprenant au moins une couche choisie parmi les couches constituées de carbure, nitrure et carbonitrure de titane, et de carbure, nitrure et carbonitrure de titane et d'un autre métal, qui ne présente pas les défauts, les inconvénients et les limitations des procédés de l'art antérieur, qui apporte une solution aux problèmes posés par les procédés de l'art antérieur, et qui réponde entre autres aux besoins mentionnés plus haut.

Ce but et d'autres encore sont atteints, conformément à l'invention, par un procédé de préparation, sur un substrat, d'un revêtement comprenant au moins une couche choisie parmi les couches constituées de nitrure de titane, les couches constituées de carbonitrure de titane TiCN, les couches constituées de nitrure de titane et d'un autre métal M : (Ti, M)N ou Ti₁₋ₓMₓN, et les couches constituées de carbonitrure de titane et d'un autre métal M : (Ti,M)NC ou Ti₁₋ₓMₓNC dans lequel ledit revêtement est déposé en continu et en une seule opération, par dépôt chimique en phase vapeur assisté par plasma, à partir d'un mélange gazeux comprenant un gaz réducteur, de l'hydrogène, éventuellement un hydrocarbure, et en tant que précurseurs des chlorures de titane et éventuellement d'un autre métal M, lesdits précurseurs étant préparés in-situ par passage de tétrachlorure de titane TiCl₄ sur une charge ou cible de métal M solide.

On note que, selon l'invention, d'une part on utilise pour la chloruration du tétrachlorure de titane, TiCl₄, liquide ce qui permet de limiter les problèmes de corrosion rencontrés lors de l'emploi de l'acide chlorhydrique : HCl liquide ou du dichlore gazeux : Cl₂.

Le TiCl₄ qui joue de manière originale le rôle de vecteur gazeux du titane rend possible la formation des chlorures mais aussi des sous-chlorures de titane et de métal tels que par exemple TiCl₃ ainsi que AlClₓ (avec x=1 ou 2) par chloruration d'une charge de métal pur tel que de l'aluminium et non d'alliage tel que TiAl. Une telle charge ou cible métallique solide en métal pur est nettement moins chère et plus facilement disponible que les charges d'alliage. De plus, l'utilisation d'une charge métallique pure par exemple d'aluminium permet de s'affranchir des problèmes de contamination éventuels par des éléments additifs présents dans les charges d'alliage Ti-Métal élaborées industriellement comme le chrome, le niobium, le vanadium, etc. La contamination des couches déposées est ainsi évitée et leur qualité maîtrisée.

Le procédé selon l'invention, de par essentiellement la nature spécifique de la charge et des composés mis en oeuvre pour la chloruration surmonte donc l'ensemble des problèmes posés par les procédés de CVD et particulièrement les procédés de CVD assistés par plasma.

Le procédé de dépôt selon l'invention, est également simple, facile à mettre en oeuvre, et d'une grande souplesse et flexibilité.

En outre, le procédé selon l'invention par CVD assisté par plasma s'affranchit totalement des inconvénients du procédé par PVD en particulier en ce qui concerne le dépôt d'un revêtement multicouche.

Le dépôt d'un revêtement multicouche même très complexe qui peut présenter une succession complexe d'un très grand nombre de couches de nature et/ou de composition différentes est possible selon l'invention par dépôt chimique en phase vapeur assisté par plasma en une seule opération réalisée en continu, sans arrêt, sans procéder à une changement de charge (cible) et/ou à un transfert du substrat revêtu d'une enceinte vers une autre enceinte, ce qui est le cas des procédés connus mettant en oeuvre la technique de PVD.

Selon l'invention, au contraire des procédés par PVD, il est possible préalablement et/ou au cours du processus de dépôt par CVD, sans avoir recours à aucune opération d'adaptation lourde et compliquée, et sans arrêt de ce processus, d'ajuster instantanément, à volonté, et en permanence, la nature et/ou la composition de la couche déposée ou de chaque couche déposée en agissant simplement sur un ou plusieurs des paramètres opératoires du procédé, en conservant par ailleurs une source unique de métal (et non d'alliage), tout au long de l'opération de dépôt.

Ainsi, selon l'invention, il est possible d'adapter instantanément la nature et/ou la composition de la (revêtement monocouche) ou de chaque couche (revêtement multicouche) au cours de l'opération de dépôt en modifiant le rapport molaire gaz réducteur sur hydrogène dans le mélange gazeux.

Selon l'invention, il est donc possible en agissant simplement sur le rapport molaire gaz réducteur sur hydrogène, c'est-à-dire encore sur la quantité molaire de gaz réducteur et notamment sur le débit de celui-ci, de modifier et de choisir la nature de chaque couche déposée, sans arrêter l'opération de dépôt, c'est-à-dire que l'on peut faire en sorte que la couche déposée soit par exemple du TiN pur ou du (Ti,M)N par exemple du (Ti, Al)N sans qu'il soit nécessaire de changer la cible ou charge.

Le gaz « réducteur » est généralement de l'ammoniac ou de l'azote. On emploie le terme « réducteur » pour l'azote par commodité de vocabulaire, bien que dans l'absolu, l'azote ne puisse être, éventuellement, considéré comme réducteur.

Le rapport molaire gaz réducteur sur hydrogène dans le mélange gazeux est généralement de 0,01 à 1.

On peut également choisir de manière précise, en ajustant le rapport molaire gaz réducteur sur hydrogène ou la quantité de gaz réducteur, la composition de la couche ou de chaque couche de (Ti, M)N par exemple de (Ti,Al)N ou Ti₁₋ₓAlₓN dans toute la gamme des valeurs possibles pour la proportion de métal par exemple d'aluminium définie par la valeur x, la charge ou cible restant la même que pour le dépôt des couches de TiN, c'est-à-dire que x peut aller de 0 à 1.

A titre d'exemple, la proportion de métal, en particulier d'aluminium, dans le nitrure de titane et d'un autre métal qui est par exemple l'aluminium peut varier de 0 à 70 %.

De même, on peut faire en sorte que toutes les couches de (Ti,M)N par exemple de (Ti,Al)N aient la même composition (même rapport Ti/M, par exemple Ti/Al), ou bien ou peut choisir qu'une ou plusieurs parmi ces couches, lorsque le revêtement en comporte deux ou plus, aient des compositions différentes les unes des autres, cela peut être réalisé immédiatement en modifiant simplement le rapport molaire gaz réducteur sur hydrogène ou la quantité de gaz réducteur.

Selon un aspect particulièrement avantageux de l'invention, il est possible en outre, en cours de dépôt, de modifier la composition de la couche ou de chaque couche de Ti₁₋ₓMₓN par exemple de Ti₁₋ₓAlₓN déposée afin d'obtenir par exemple une couche à gradient de composition dont la composition varie généralement de manière progressive et continue tout au long de son épaisseur, depuis une composition correspondant par exemple à une couche de TiN pur jusqu'à une couche à très forte teneur en métal par exemple en aluminium (dont la valeur de x est très élevée par exemple égale à 0,6).

Il est également possible d'ajuster la nature et/ou la composition de la couche ou de chaque couche déposée en modifiant la puissance du plasma.

La puissance du plasma peut varier par exemple de 50 à 500 W, ce qui correspond à une densité de puissance de 0,0025 W/cm³ à 0,025 W/cm³, de préférence de 50 à 300 W, ce qui correspond à une densité de puissance de 0,0025 W/cm³ à 0,015 W/cm³.

Ce qui entraîne par exemple un accroissement de la teneur en métal M tel que l'aluminium dans la couche dopée de 0 à 40 %.

De même, on peut modifier la nature et/ou la composition de chaque couche déposée en agissant sur le rapport molaire Métal M sur TiCl₄ en faisant varier le débit de TiCl₄ de façon qu'il y ait toujours un excès de métal par rapport à TiCl₄.

Il est à noter que tout ce qui a été indiqué ci-dessus pour les couches de nitrures s'applique de la même manière aux couches de carbonitrures.

Grâce au procédé selon l'invention, la composition et la nature de chaque couche peut être maîtrisée avec une grande précision. Il en résulte que les revêtements préparés présentent également des propriétés parfaitement maîtrisées.

Le procédé selon l'invention, peut être facilement adapté à la préparation d'un revêtement particulier pour une application particulière, et il permet donc de préparer toutes sortes de revêtements possédant des propriétés physico-chimique et mécaniques très variées convenant pour une large gamme d'applications qui n'étaient pas jusqu'à présent envisagées pour des revêtement de ce type.

Le procédé selon l'invention élargit ainsi considérablement le champ des applications potentielles des revêtements multicouches de (carbo)nitrure de titane et de (carbo)nitrure de titane et d'un autre métal en particulier de (carbo)nitrure de titane aluminium.

Selon l'invention, lorsqu'on souhaite préparer des couches de carbonitrure, le mélange gazeux comprend également un hydrocarbure. Cet hydrocarbure est choisi de préférence parmi les alcanes gazeux de 1 à 3 atomes de carbone tels que le méthane, l'éthane, le propane, le méthane étant préféré.

On pourrait également envisager l'utilisation d'alcènes ou d'alcynes.

Selon l'invention, le plasma peut être généré par toute technique connue.

Ainsi, selon l'invention, le plasma peut être généré par une décharge électrique en courant continu pulsé (pulse d.c. PACVD en anglais).

Selon l'invention, le plasma peut être également généré par une décharge électrique en courant alternatif radiofréquence (r.f. PACVD en anglais).

Ladite radiofréquence se situe de préférence selon l'invention dans une gamme basse fréquence, c'est-à-dire par exemple de 50 à 460 kHz, de préférence d'environ 50 kHz.

Il a en effet été mis en évidence, selon une caractéristique particulièrement avantageuse du procédé de l'invention, que des dépôts par PACVD de couches de nitrures et carbonitrures, en particulier de couches de (Ti,M)N, pouvaient aussi de manière surprenante, être réalisées dans ladite zone basse fréquence et non pas seulement dans la gamme haute fréquence qui est la seule mentionnée dans les documents de l'art antérieur.

Il est toutefois bien évident que dans l'invention ladite radiofréquence peut aussi se situer dans une gamme haute-fréquence, par exemple à 13,56 MHz.

D'autres types de décharge plasma peuvent être envisagées sans pour autant sortir du cadre de l'invention.

Selon l'invention, le procédé est généralement réalisé à une pression de 0,5.10² Pa à 5.10² Pa.

Selon l'invention, le substrat à revêtir est généralement porté à une température de 500 à 1200 K.

Selon l'invention, ladite au moins une couche déposée a généralement une épaisseur de 0,01 à 50 µm, de préférence de 0,01 à 10 µm, de préférence encore de 0,02 à 0,5 µm.

On a vu plus haut que le procédé selon l'invention convenait particulièrement au dépôt de revêtements multicouches, de tels revêtements multicouches ont par exemple de 2 à 1000 couches, de préférence de 2 à 100 couches, et ont généralement une épaisseur totale de 1 à 50 µm, chacune des couches du revêtement multicouche a généralement une épaisseur de 0,1 µm à 0,5 µm.

Enfin, dans toute la description le métal M autre que le titane est généralement choisi parmi le hafnium, le zirconium, le vanadium, le niobium, le tantale, le bore et l'aluminium, de préférence le métal M est l'aluminium.

L'invention a également trait aux revêtements en particulier aux revêtements multicouches susceptibles d'être préparés par le procédé décrit plus haut.

L'invention inclut tous les revêtements susceptibles d'être préparés par le procédé ci-dessus quelle que soit la nature, la composition, la succession et le nombre de couches déposées.

L'invention concerne aussi les revêtements multicouches suivants.

Il s'agit, d'une part, des revêtements multicouches comprenant un empilement de plusieurs couches choisies parmi les couches constituées de Ti(C)N et les couches constituées de (Ti,M)(C)N, par exemple de (Ti,Al)(C)N, qui comprennent au moins une couche de (Ti,M)(C)N par exemple de (Ti,Al)(C)N à gradient de composition.

Il s'agit, d'autre part, des revêtements multicouches qui comprennent un empilement de plusieurs couches choisies parmi les couches constituées de Ti (C) N et de Ti₁₋ₓAlₓ(C)N (ou (Ti, Al) (C) N) et qui comprennent au moins deux couches de Ti₁₋ₓAlₓ(C)N, au moins un de ces couches de Ti₁₋ₓAlₓ(C)N ayant une composition différente de l'autre ou des autre(s) couche (s) de Ti₁₋ₓAlₓ(C)N.

De préférence, dans ce cas, au moins une de ces couches de Ti₁₋ₓAlₓ(C)N est une couche à gradient de composition.

De préférence, les couches de Ti(C)N et de Ti₁₋ₓAlₓ(C)N sont alternées mais le revêtement peut également comprendre un empilement de couches constituées uniquement de Ti₁₋ₓAlₓ(C)N, chaque couche ayant une composition différente (de la couche précédente et de la couche suivante) , ou les couches ayant par exemple deux à deux des compositions analogues, c'est-à-dire que les couches « impaires » ont une composition définie et les couches « paires » ont une autre composition définie.

D'autres caractéristiques et avantages de l'invention apparaîtront mieux à la lecture de la description qui suit, donnée à titre illustratif, mais non limitatif, en références aux figures annexées sur lesquelles :

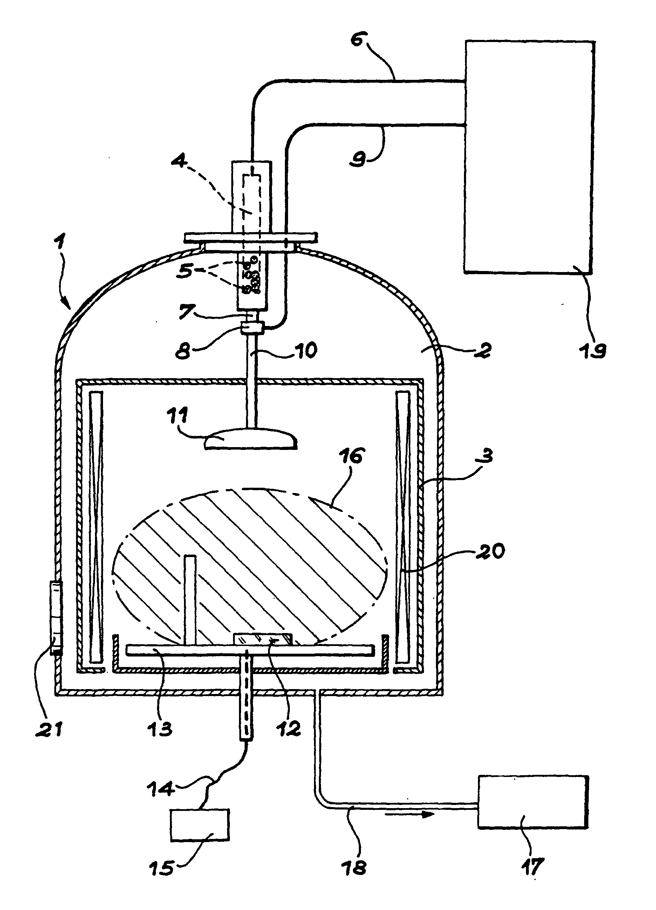

- la figure 1 représente une vue en coupe schématique d'un exemple d'un dispositif permettant l'élaboration des revêtements selon l'invention.

Le procédé selon l'invention comprend plus précisément, par exemple, la succession d'étapes suivantes, qui sont des étapes classiques dans les procédés de CVD assistés par plasma pour le dépôt d'une couche de revêtement :
La première étape consiste à former « in situ » des chlorures métalliques de titane et d'un autre métal en partant d'une charge, dans le cas du procédé selon l'invention d'une charge métallique solide unique, du métal autre que le titane, choisi de préférence parmi le hafnium, le zirconium, le vanadium, le niobium, le tantale, le bore et l'aluminium, de préférence encore ce métal est l'aluminium.

Le métal autre que le titane est généralement utilisé sous la forme de barreaux ou copeaux car une telle forme favorise la chloruration.

L'opération de chloruration est réalisée selon une caractéristique essentielle de l'invention en utilisant du tétrachlorure de titane liquide (TiCl₄), de préférence additionné d'un gaz diluant ou gaz vecteur tel que de l'argon dans une proportion TiCl₄/Ar = 1/2 par exemple.

La charge métallique est de préférence portée à une température de 873 à 930 K et la chloruration ou balayage du TiCl₄ sur la charge est généralement effectuée à une pression de 0,5 x 10² à 5 x 10² Pa.

La quantité de TiCl₄ est de préférence choisie pour obtenir une réaction ou chloruration totale du métal, ainsi le métal tel que l'aluminium est-il généralement en excès par rapport au TiCl₄.

Par exemple, pour une quantité de métal tel que de l'aluminium de 10 moles, la quantité de TiCl₄ est de préférence de 1 mole.

Il y a formation de l'alliage TiAl₃ et la phase gazeuse est alors principalement composée des espèces AlCl₃ et TiCl₃, lorsqu'on se place de préférence à une température de 920 K et à une pression de 10² Pa, et la quantité molaire de AlCl₃ produit est environ dix fois supérieure à la quantité de TiCl₃, et des autres chlorures de titane gazeux qui peut donc être considérée comme négligeable.

On montre également qu'il n'y a pas d'évolution de la charge, c'est-à-dire que le rapport Ti/M tel que Ti/Al reste identique. Un tel rapport TiCl₄/Metal est donc à retenir par exemple pour la synthèse de nitrure d'aluminium ou encore de films de (Ti,Al)N avec un rapport Al/Ti élevé.

La deuxième étape consiste à mélanger les produits gazeux issus de la chloruration avec le gaz réducteur, l'hydrogène et éventuellement un hydrocarbure gazeux et/ou un gaz vecteur ou porteur choisi par exemple parmi l'argon, l'hélium et leurs mélanges.

Le gaz réducteur est choisi de préférence parmi l'azote, et l'ammoniac, l'azote étant encore préféré. L'opération de mélange est généralement réalisée à une température de 723 K. à 873 K.

On note que dans le cas de l'azote, on ne peut à proprement parler employer le terme « gaz réducteur » utilisé par commodité, le terme « réducteur » s'applique plutôt au mélange gazeux azote et hydrogène.

Selon l'invention, il est possible de faire varier la composition des couches déposées en agissant simplement sur le rapport molaire gaz réducteur, par exemple NH₃ ou N₂, sur hydrogène dans le mélange gazeux.

Il apparaît qu'une augmentation du rapport molaire gaz réducteur, par exemple NH₃ ou N₂, sur hydrogène, permet d'accroître la proportion de métal M autre que le titane, par exemple d'aluminium par rapport au titane dans la couche déposée.

Dans le cas où la quantité d'hydrogène, et par voie de conséquence son débit est constant, on peut alors également se référer simplement à la quantité molaire de gaz réducteur, tel que NH₃ ou N₂, dans le mélange, dont l'augmentation accroît la proportion de métal autre que le titane par exemple d'aluminium.

Si le débit de H₂ est constant on augmente facilement la proportion de métal M, par exemple d'aluminium en augmentant le débit de gaz réducteur.

Le rapport molaire gaz réducteur sur hydrogène, par exemple NH₃ ou N₂/H₂, dans le mélange gazeux, peut varier par exemple de 0,01 à 1 ; par exemple, pour un rapport molaire d'environ 0,01, on prépare du TiN, tandis que pour des rapports molaires de 0,02 à 0,1, on prépare des nitrures de titane et de métal par exemple d'aluminium avec x variant de 0,05 à 0,6 par exemple Ti_{0,95}Al_{0,05}N ou Ti_{0,4}Al_{0,6}N.

Il semblerait, sans vouloir être lié par aucune théorie qu'une augmentation de la concentration en gaz réducteur, par exemple en NH₃ ou N₂, favorise la décomposition des chlorures de métal M tel que les chlorures d'aluminium, et par conséquent accroisse la quantité de nitrure de métal M tel que des nitrures d'aluminium déposée.

Dans le mélange gazeux, la quantité molaire de gaz réducteur, par exemple de NH₃ ou N₂, et la quantité molaire d'hydrogène, sont toutes deux généralement en excès par rapport à la quantité molaire de chlorures de titane et de métal M par exemple d'aluminium générés. Par exemple, la quantité molaire de gaz réducteur, tel que NH₃ ou N₂, est supérieure, de préférence nettement supérieure à la quantité molaire de chlorures, tandis que la quantité molaire d'hydrogène est de préférence au moins 2 fois, de préférence encore au moins 3 fois, mieux au moins 5 fois supérieure à la quantité molaire de chlorures.

Si l'on souhaite élaborer un revêtement carbonitruré par exemple de TiAlCN, il y a lieu d'ajouter en outre un hydrocarbure gazeux par exemple un alcane de 1 à 3 C, tel que du méthane, de l'éthane ou du propane. On pourrait également envisager l'utilisation d'alcènes ou d'alcynes.

Suite au mélange des produits issus de la chloruration avec le gaz réducteur, l'hydrogène et éventuellement l'hydrocarbure gazeux et/ou le gaz vecteur tel que l'argon, on procède à la phase de dépôt proprement dite, par réaction en milieu plasmagène des éléments présents en phase gazeuse avec la surface chaude du substrat à revêtir, selon le principe généralement mis en oeuvre dans la technique du dépôt chimique en phase assisté par plasma (PACVD).

Comme on l'a déjà indiqué ci-dessus, le plasma utilisé dans le procédé de PACVD selon l'invention est de préférence un plasma généré par une décharge en courant alternatif radiofréquence de préférence dans la gamme basse fréquence de 50 à 460 kHz.

De même et quelle que soit la nature du plasma, la variation de la puissance du plasma permet de modifier la nature et/ou la composition des couches déposées.

La puissance du plasma influence en effet le rapport Ti/M tel que Ti/Al, ainsi une variation de 50 à 150 W engendre par exemple un accroissement de la teneur en métal tel que Al de 1% à 37%. Ce phénomène s'explique par la présence d'un mécanisme de dissociation plus important pour les plus fortes densités de puissance en PACVD.

Le ou les substrat (s) qui peuvent être revêtu(s) par le procédé de l'invention sont de préférence des substrats en métaux tels que des substrats en acier par exemple en acier au carbone ou en acier inox.

Mais des substrats en d'autres matériaux tels que des substrats en silicium par exemple des substrats en silicium monocristallin de type <110> ou encore <100> peuvent également être revêtus par le procédé selon l'invention.

Le substrat peut prendre une forme quelconque, mais il de préférence constitué par des pièces usinées, finies, par exemple des pièces faisant partie d'outils de coupe, ou d'autres outils.

De même, il est possible de ne revêtir qu'une partie de la surface du substrat, une autre partie n'étant pas revêtue, ou bien revêtue d'un dépôt de nature différente.

La température à laquelle est porté le substrat est de préférence de 500 à 1 200 K, de préférence encore de 723 à 873 K, par exemple de 773 K et le dépôt est réalisé généralement à une pression voisine de 10² Pa, par exemple de 113 Pa (1 mbar).

La vitesse de dépôt dépend des paramètres du procédé et de la nature du substrat et est généralement de 0,1 à 10 µm/h, de préférence de 0,5 à 5 µm/h.

Du fait que l'ensemble du dépôt multicouche peut être réalisé en une seule opération, en continu, sans arrêt, sans changement de la cible, la durée totale du dépôt par le procédé selon l'invention, qui est par exemple de 15 minutes à 5 heures, est très nettement inférieure à la durée du dépôt d'un revêtement multicouche par PVD qui est généralement de 10 heures à plusieurs dizaines d'heures du fait des arrêts intervenant entre le dépôt de chaque couche, et sans tenir compte en outre du temps nécessaire à la préparation des cibles PVD.

Cette durée réduite du dépôt constitue l'un des avantages supplémentaires du procédé selon l'invention.

Comme on l'a déjà indiqué plus haut, la nature, la composition, la succession, et le nombre de couches déposées sont variables.

La caractéristique fondamentale du procédé et de permettre sans changer la cible, dans une même enceinte, en continu, le dépôt soit de couches de TiN pur, soit de couches de Ti₁₋ₓAlₓN, les couches de (Ti,Al)N pouvant avoir des compositions différentes les unes des autres, les couches de (Ti,Al)N pouvant aussi présenter un gradient de composition, le gradient de composition pouvant être quelconque.

La succession des couches peut être variable c'est-à-dire que des couches de TiN peuvent par exemple alterner avec des couches de (Ti,Al)N, chacune des couches de (Ti,Al)N ayant la même composition ou une ou plusieurs des couches de (Ti,Al)N ayant une composition différentes des autres couches de (Ti,Al)N.

L'empilement des couches peut également ne comporter que des couches de (Ti,Al)N, chaque couche ayant une composition différente de la couche qui la suit et de la couche qui la précède dans l'empilement.

A titre d'exemple de revêtement, on peut citer un revêtement bicouche comprenant sur le substrat une couche de TiN, puis une couche de (Ti,Al)N dont la proportion de Al peut être quelconque, ou un revêtement bicouche formé d'une couche de (Ti,Al)N sur le substrat, puis d'une autre couche de (Ti,Al)N de composition différente de la première.

Dans ce qui précède une ou plusieurs des couches peuvent être en outre carburées, il suffit pour cela d'introduire l'hydrocarbure nécessaire lorsqu'on procède au dépôt de cette ou de ces couches.

Le nombre de couches déposées est généralement de 2 à quelques dizaines ou quelques centaines, par exemple de 2 à 1 000, de préférence de 2 à 100.

L'épaisseur de chaque couche déposée est généralement de 0,01 à 50 µm, de préférence de 0,01 à 10 µm, de préférence encore de 0,02 à 0,5 µm, mieux de 0,02 à.0,05 µm.

L'épaisseur totale du revêtement monocouche est généralement de 0,01 à 50 µm et celle du revêtement multicouche de 1 à 50 µm.

Donc des couches du revêtement multicouche a généralement une épaisseur de 0,1 µm à 0,5 µm.

Cette épaisseur totale dépend notamment de l'application recherchée.

Ainsi, pour des applications mécaniques, par exemple pour protéger un outil des rayures, on utilisera de préférence une épaisseur de 2 à 5 µm, tandis que pour des applications de protection contre la corrosion par les métaux liquides, on utilisera de préférence une épaisseur minimale de 10 µm.

Selon un mode de réalisation particulièrement avantageux de la présente invention, il est possible d'associer un traitement thermochimique, tel qu'une nitruration thermique ou chimique ou encore une carburation, au procédé de dépôt par CVD thermique selon l'invention.

Le traitement thermochimique et le dépôt d'un revêtement par PACVD thermique peuvent être mis en oeuvre successivement dans la même installation, par exemple dans l'enceinte où est réalisée le dépôt, sans remise à l'air intermédiaire des substrats.

Le traitement thermochimique peut être réalisé préalablement au dépôt afin de conférer une excellente adhérence au revêtement et d'obtenir un meilleur comportement mécanique global par un effet durcissant de la couche, ou bien en phase finale, ce qui assure une protection supplémentaire du revêtement.

En outre, si l'on opère en plasma à courant alternatif, il est également possible, de manière particulièrement avantageuse selon l'invention et contrairement aux procédés mettant en ouvre un plasma à courant continu de déposer une couche protectrice finale par exemple de quelques micromètres d'épaisseur, c'est-à-dire de préférence de 0,1 à 1 µm à base d'oxyde du métal M, par exemple d'alumine. On introduit pour cela dans l'enceinte réactionnelle, à la fin du procédé, (c'est-à-dire à la fin de la phase de dépôt) préférentiellement du dioxyde de carbone gazeux CO₂.

Sur la figure 1, on a représenté de manière très schématique un exemple de réacteur convenant pour la mise en oeuvre du procédé selon l'invention.

Selon la figure 1, le réacteur 1 comprend une enceinte de dépôt chimique en phase vapeur 2 montée sur un châssis comprenant une chambre de dépôt 3 ainsi qu'une chambre de chloruration ou chambre intermédiaire 4 dans laquelle est placée, selon l'invention, une charge de métal par exemple une charge d'aluminium monocristallin sous forme solide 5. La chambre de chloruration ou chambre intermédiaire 4 peut par exemple prendre la forme d'un tube fermé par un fond perforé qui est alimenté en TiCl₄ éventuellement additionné d'argon par la canalisation 6. La chambre de chloruration est portée par exemple à la température de 900K par un dispositif de chauffage adéquat tel qu'un système de résistances chauffantes (non représenté). Des calculs préliminaires permettent de fixer le débit de TiCl₄ de façon à ce que la réaction avec l'aluminium soit totale.

Les produits issus de la chloruration de la charge par exemple d'aluminium dans la chambre intermédiaire 4 sont ensuite envoyés par une canalisation 7 - vers une chambre ou zone de mélange 8 - qui est également prévue pour recevoir les autres gaz nécessaires au procédé : à savoir l'hydrogène, le gaz réducteur tel que l'ammoniac ou l'azote, et éventuellement un hydrocarbure tel que le méthane et un gaz vecteur tel que l'argon. Ces gaz sont injectés de préférence, latéralement dans ladite zone de mélange par l'intermédiaire de la canalisation 9.

Le mélange gazeux est ensuite acheminé par la canalisation 10 vers un système d'injection de gaz 11 prévu dans la chambre de dépôt. Ce système peut par exemple prendre la forme de douche.

La chambre de dépôt 3 est constituée par une "enceinte à parois chaudes" de forme sensiblement cylindrique qui a un diamètre utile par exemple de 300 mm et une hauteur utile par exemple de 300 mm.

Dans cette chambre le substrat 12 ou pièce à traiter est placé sur un support ou porte-substrat 13 adéquate. Ce support ou porte-substrat peut par exemple prendre la forme d'un plateau en Inconel® (« Inconel » est une marque déposée), par exemple de 260 mm de diamètre. Le support ou porte-substrat joue également le rôle d'électrode.

L'électrode est alimentée par l'intermédiaire de la ligne 14 par exemple par un générateur radiofréquence 15 par exemple en gamme basse fréquence, c'est-à-dire de 50 kHz à 460kHz.

Le générateur délivre une puissance maximale de 500 W et est régulé en puissance et est pilotable à distance. La décharge électrique dans le milieu gazeux de la chambre de dépôt crée un plasma 16 autour du substrat.

Les substrats sont par ailleurs chauffés par conduction à la température voulue grâce aux résistances chauffantes disposées le long de la paroi (20).

Le support ou porte-substrat 13 est également relié à un thermocouple permettant de mesurer en permanence la température du substrat.

Un groupe de pompage sec 17 est relié à la partie inférieure de la chambre de réaction par la canalisation 18 et permet de réaliser et de maintenir la pression voulue à l'intérieur de l'enceinte. Ce groupe de pompage se compose d'une pompe sèche d'un début maximal égal par exemple à 80 m³/h et d'une pompe "Roots" d'un débit maximal égal par exemple à 300 m³/h.

Le réacteur est également pourvu de moyens d'alimentation en gaz sous forme par exemple d'un « panneau de gaz » 19 équipé d'un minimum de 5 lignes, comprenant une armoire métallique étanche de commande munie d'un orifice de ventilation réservé aux gaz chlorés.

L'armoire de commande présente des tiroirs de commande de pompage, de débits de gaz, et de pression totale ; la mesure de la pression est fournie par une jauge capacitive, et elle est maintenue constante en pilotant le débit total des gaz.

Chaque ligne de gaz, en particulier celle de gaz réducteur tel que NH₃, est équipée d'un débitmètre massique à régulation électronique et d'une vanne d'arrêt télécommandée qui sont reliés à l'armoire de commande munie de dispositifs d'affichage du débit par exemple numérique et de réglage simultané. On peut donc agir à volonté, instantanément, au cours du procédé sur les débits gazeux, en particulier de gaz réducteur tel que NH₃, et par voie de conséquence sur la nature et la composition des couches déposées.

Un débitmètre massique spécifique calorifugé est prévu pour le tétrachlorure de titane liquide.

Le réacteur comprend également des moyens de chauffage et de régulation de la température permettant d'atteindre et de maintenir les températures de chloruration et de dépôt.

Dans le réacteur présenté sur la figure 1, les moyens de chauffage sont des moyens résistifs et peuvent être réalisé sous la forme d'une série de résistances 20 longeant la paroi de la chambre de dépôt et régulées en température par un contrôle de la puissance électrique dissipée dans les résistances.

Les chambres de dépôt et de chloruration peuvent être chauffées avec les mêmes moyens de chauffage ou il peut être prévu des moyens de chauffage séparés, résistifs, pour chauffer chacune de ces chambres.

Des moyens d'observation tels que des hublots 21, de préférence en quartz peuvent être prévus dans l'enceinte par exemple dans la paroi latérale.

Enfin, des moyens de gestion et de pilotage informatique du procédé tels que des logiciels spécifiquement développés sont également prévus. Ces moyens permettent en particulier de gérer informatiquement les débits gazeux et de maîtriser parfaitement l'épaisseur des couches suivantes élaborées.

Les revêtements selon l'invention trouvent notamment leur application dans tous les domaines où sont déjà mis en oeuvre des revêtements à base de nitrure ou carbonitrure de titane, en particulier dans le domaine de la mécanique par exemple dans le domaine de l'outillage (usinage avec fort échauffement), et plus particulièrement par exemple pour le (Ti,Al)N, dans des applications de protection contre l'oxydation à haute température et contre la corrosion par les métaux liquides, par exemple l'aluminium liquide et ses alliages, ou par l'uranium liquide et ses alliages tel que l'uranium-fer.

Les exemples suivants, donnés à titre illustratif et non limitatif, illustrent le procédé de l'invention.

### EXEMPLE 1

Cet exemple illustre des conditions permettant d'obtenir un dépôt de nitrure de titane aluminium (Ti,Al)N ou Ti₁₋ₓAlₓN sur divers substrats.

Le dispositif mis en oeuvre est sensiblement analogue à celui de la figure 1. Les paramètres du procédé sont les suivants :
- Température de chloruration : 900 K
- Température de dépôt : 773 K
- Pression totale : 100 Pa
- Débits gazeux (cm³/min) :
   - TiCl₄ :: 15
   - N₂ :: 750
   - H₂ :: 750
   - Ar :: 500
- Puissance du plasma : 150 W (densité de puissance, 0,0075 W/cm³)
- Substrats :
   - Acier (type 3oCD4),
   - Acier inoxydable nuance X2CrNi18.10
   - Silicium orienté <110>.

La vitesse de dépôt est de l'ordre de 2 à 3 µm/h suivant les substrats utilisés.

Le dépôt obtenu, est constitué, en utilisant les conditions opératoires ci-dessus de nitrure de titane aluminium (Ti,Al) N ou Ti₁₋ₓAlₓN présentant un rapport atomique Ti/Al défini et égal à 38/62.

La nature du dépôt a été déterminée par diffraction aux rayons X.

Les épaisseurs des dépôts ont été déterminées par observation au MEB (Microscope Electronique à Balayage) de coupes métallographiques des échantillons obtenus et ont été trouvés dans une gamme allant de 2 µm pour l'acier à 2,5 µm pour l'acier inoxydable et à 3 µm pour le silicium dans les conditions de dépôts citées précédemment.

Les rapports Ti/Al ont été déterminés par une analyse effectuée par EDS (Spectrométrie à Dispersion d'Energie, en anglais Energy Dispersive Spectroscopy).

### EXEMPLE 2

Cet exemple illustre, de la même manière que l'exemple 1, des conditions permettant d'obtenir un dépôt de nitrure de titane aluminium (Ti,Al)N ou Ti₁₋ₓAlₓN sur divers substrats.

Le dispositif est sensiblement analogue à celui de la figure 1.

Les paramètres du procédé sont les mêmes que ceux de l'exemple 1 sauf que le débit d'azote est de 500cm³/minute au lieu de 750cm³/minute et que le débit d'hydrogène est de 1000cm³/minute au lieu de 750cm³/minute. Les substrats sont également les mêmes que dans l'exemple 1.

La vitesse de dépôt est de l'ordre de 0,6µm/h pour tous les substrats utilisés.

Le dépôt obtenu est constitué, en utilisant les conditions opératoires ci-dessus de nitrure de titane aluminium (Ti,Al)N ou Ti₁₋ₓAlₓN présentant un rapport atomique Ti/Al défini et égal à 63/37.

Les épaisseurs des dépôts ont été trouvées dans la gamme allant de 0,5 µm pour l'acier à 0,6 µm pour l'acier inoxydable et à 0,8 µm pour le silicium.

La nature, l'épaisseur des dépôts, et le rapport Ti/Al ont été déterminés de la même manière que dans l'exemple 1.

### EXEMPLE 3 (puissance 50 W) (densité de puissance 0,0025 W/cm³)

Cet exemple illustre, de la même manière que les exemples 1 et 2 des conditions permettant d'obtenir un dépôt de nitrure de titane aluminium (Ti,Al)N ou Ti₁₋ₓAlₓ sur divers substrats.

Le dispositif est sensiblement analogue à celui de la figure 1.

Les paramètres du procédé sont les mêmes que ceux de l'exemple 2, sauf que la puissance du plasma est de 50W. Les substrats sont également les mêmes que ceux de l'exemple 2.

La vitesse de dépôt est de l'ordre de 2 µm/h pour tous les substrats utilisés.

Le dépôt obtenu est constitué en utilisant les conditions opératoires ci-dessus de nitrure de titane aluminium présentant un rapport atomique Ti/Al défini et égal à 99/1.

Les épaisseurs des dépôts ont été trouvées dans la gamme allant de 4 µm pour l'acier à 4,5 µm pour l'acier inoxydable et à 5 µm pour le silicium.

La nature, l'épaisseur des dépôts, et le rapport Ti/Al ont été déterminés de la même manière que dans l'exemple 1.

### EXEMPLE 4

Cet exemple illustre les conditions permettant d'obtenir un dépôt de carbonitrure de titane aluminium Ti-Al-C-N sur divers substrats.

Le dispositif mis en oeuvre est sensiblement analogue à celui de la figue 1.

Les paramètres du procédé sont les suivants :
- Température de chloruration : 900 K
- Température de dépôt : 773 K
- Pression totale : 100 Pa
- Débits gazeux (cm³/min) :
   - TiCl₄ :: 15
   - N₂ :: 750
   - H₂ :: 750
   - Ar :: 500
   - CH₄ :: 150
- Puissance du plasma : 150 W (densité de puissance de 0,0075 W/cm³)
- Substrats :
   - Acier (type 30CD4),
   - Acier inoxydable(nuance X2CrNil8.10), et
   - Silicium orienté <110>.

La vitesse de dépôt est de l'ordre de 1 µm/h pour tous les substrats utilisés.

Le dépôt obtenu est constitué en utilisant les conditions opératoires ci-dessus de carbonitrure de titane aluminium Ti-Al-C-N.

Les épaisseurs des dépôts ont été.trouvées dans la gamme de 2 µm pour l'acier à 2,5 µm pour l'acier inoxydable, et à 3 µm pour le silicium.

La nature et l'épaisseur des dépôts ont été déterminées de la même manière que dans l'exemple 1.

Les exemples ci-dessus mettent en évidence l'influence des divers paramètres expérimentaux sur la composition des couches, et notamment du rapport N₂/H₂ et de la puissance plasma. Il apparaît dans les exemples 1 et 2 qu'une élévation de ce rapport permet d'accroître la proportion d'aluminium par rapport au titane dans le dépôt, par exemple, en augmentant ce rapport de 0,5 à 1, le pourcentage d'aluminium fluctue de 37 à 62%.

De même, comme le montrent les exemples 2 et 3, l'influence de la puissance du plasma sur le rapport Ti/Al est également importante dans la mesure où une variation de 50 W à 150 W ; c'est-à-dire une variation de la densité de puissance de 0,0025 à 0,0075 W/cm³ engendre un accroissement de la teneur en Al de 1% à 37%.

## Revendications

1. Procédé de préparation sur un substrat, d'un revêtement comprenant au moins une couche choisie parmi les couches constituées de nitrure de titane TiN, les couches constituées de carbonitrure de titane TiCN, les couches constituées de nitrure de titane et d'un autre métal M Ti₁₋ₓMₓN et les couches constituées de carbonitrure de titane et d'un autre métal M Ti₁₋ₓMₓNC; dans lequel ledit revêtement est déposé en continu et en une seule opération, par dépôt chimique en phase vapeur assisté par plasma (PACVD), à partir d'un mélange gazeux comprenant un gaz réducteur, de l'hydrogène, éventuellement un hydrocarbure, et en tant que précurseurs des chlorures de titane et éventuellement d'un autre métal M, lesdits précurseurs étant préparés in-situ par passage de tétrachlorure de titane TiCl₄ sur une charge ou cible de métal M solide.

2. Procédé selon la revendication 1, dans lequel on ajuste instantanément préalablement à et/ou au cours de l'opération de dépôt par PACVD la nature et/ou la composition de la ou de chaque couche déposée en agissant sur un ou plusieurs des paramètres opératoires du procédé.

3. Procédé selon la revendication 2, dans lequel on ajuste la nature et/ou la composition de la ou de chaque couche déposée en modifiant le rapport molaire gaz réducteur sur hydrogène dans le mélange gazeux et/ou la puissance du plasma

4. Procédé selon la revendication 1, dans lequel le gaz réducteur est de l'ammoniac NH₃.

5. Procédé selon la revendication 1, dans lequel le gaz réducteur est de l'azote.

6. Procédé selon la revendication 1, dans lequel le rapport molaire gaz réducteur sur hydrogène dans le mélange gazeux est de 0,01 à 1.

7. Procédé selon l'une quelconque des revendications 1 à 6, dans lequel la puissance du plasma est de 0,0025 à 0,025 W/cm³.

8. Procédé selon l'une quelconque des revendications 1 à 7, dans lequel le métal M autre que le titane est en excès par rapport au TiCl₄.

9. Procédé selon la revendication 1, dans lequel ledit hydrocarbure gazeux est choisi parmi les alcanes de 1 à 3 C, tels que le méthane.

10. Procédé selon la revendication 1, dans lequel le plasma est généré par une décharge électrique en courant continu pulsé ("pulsed d.c. PACVD").

11. Procédé selon la revendication 1, dans lequel le plasma est généré par une décharge électrique en courant alternatif radiofréquence ("r.f. PACVD").

12. Procédé selon la revendication 11, dans lequel ladite radiofréquence se situe dans une gamme basse fréquence de 50 kHz à 460 kHz.

13. Procédé selon la revendication 11, dans lequel ladite radiofréquence se situe à haute fréquence telle que 13,56 MHz.

14. Procédé selon l'une quelconque des revendications 1 à 13, dans lequel la pression est de 50 à 500 Pa.

15. Procédé selon l'une quelconque des revendication 1 à 14, dans lequel le substrat à revêtir est porté à une température de 500 à 1200K.

16. Procédé selon l'une quelconque des revendications 1 à 15, dans lequel ladite couche a une épaisseur de 0,01 à 50 µm.

17. Procédé selon la revendication 16, dans lequel ledit revêtement comprend une seule couche.

18. Procédé selon l'une quelconque des revendications 1 à 16, dans lequel ledit revêtement est un revêtement multicouche comprenant de 2 à 100 couches.

19. Procédé selon la revendication 18, dans lequel ledit revêtement a une épaisseur totale de 1 à 50µm.

20. Procédé selon l'une quelconque des revendications 18 et 19 dans lequel chaque couche a une épaisseur de 0,1 µm à 0,5 µm.

21. Procédé selon l'une quelconque des revendications 1 à 20, dans lequel ledit métal M autre que le titane est choisi parmi le hafnium, le zirconium, le vanadium, le niobium, le tantale, le bore et l'aluminium.

22. Procédé selon l'une quelconque des revendications 1 à 21, **caractérisé en ce que** préalablement ou consécutivement à l'opération de dépôt on effectue en outre un traitement thermochimique dans la même enceinte.

23. Procédé selon la revendication 22, **caractérisé en ce que** ledit traitement thermochimique est choisi parmi les nitrurations thermiques ou chimiques et les carburations.

24. Procédé selon la revendication 11, dans lequel on dépose une couche protectrice finale à base d'oxyde du métal M autre que le titane en introduisant dans l'enceinte réactionnelle à la fin du procédé du dioxyde de carbone gazeux.

## Claims

1. Process for the preparation on a substrate of a coating comprising at least one layer chosen from among layers constituted by titanium nitride TiN, layers constituted by titanium carbonitride TiCn, layers constituted by titanium nitride and another metal M Ti₁₋ₓMₓN and layers constituted by titanium carbonitride and another metal M Ti₁₋ₓMₓNC, wherein said coating is continuously deposited in a single operation by plasma assisted chemical vapour deposition (PACVD) from a gaseous mixture comprising a reducing gas, hydrogen, optionally a hydrocarbon and as precursors titanium chlorides and optionally another metal M, said precursors being prepared in situ by passing titanium tetrachloride TiCl₄ onto a charge or target of solid metal M.

2. Process according to claim 1, wherein there is an instantaneous adjustment beforehand and/or during the PACVD deposition operation of the nature and/or the composition of the or each layer deposited by acting on one or more operating parameters of the process.

3. Process according to claim 2, wherein an adjustment takes place to the nature and/or the composition of the or each layer deposited by modifying the molar ratio of reducing gas to hydrogen in the gaseous mixture and/or the power of the plasma.

4. Process according to claim 1, wherein the reducing gas is ammonia NH₃.

5. Process according to claim 1, wherein the reducing gas is nitrogen.

6. Process according to claim 1, wherein the molar ratio of reducing gas to hydrogen in the gaseous mixture is 0.01 to 1.

7. Process according to any one of the claims 1 to 6, wherein the power of the plasma is 0.0025 to 0.025 W/cm³.

8. Process according to any one of the claims 1 to 7, wherein the metal M, other than titanium, is in excess compared with TiCl₄.

9. Process according to claim 1, wherein said gaseous hydrocarbon is chosen among 1 to 3 C alkanes, such as methane.

10. Process according to claim 1, wherein the plasma is generated by a pulsed direct current electric discharge.

11. Process according to claim 1, wherein the plasma is generated by a radio frequency alternating current electric discharge.

12. Process according to claim 11, wherein said radio frequency is in a low frequency range of 50 kHz to 460 kHz.

13. Process according to claim 11, wherein said radio frequency is at a high frequency such as 13.56 MHz.

14. Process according to any one of the claims 1 to 13, wherein the pressure is 50 to 500 Pa.

15. Process according to any one of the claims 1 to 14, wherein the substrate to be coated is raised to a temperature of 500 to 1200 K.

16. Process according to any one of the claims 1 to 15, wherein said layer has a thickness of 0.01 to 50 µm.

17. Process according to claim 16, wherein said coating comprises a single layer.

18. Process according to any one of the claims 1 to 16, wherein said coating is a multilayer coating comprising 2 to 100 layers.

19. Process according to claim 18, wherein said coating has a total thickness of 1 to 50 µm.

20. Process according to either of the claims 18 and 19, wherein each layer has a thickness of 0.01 to 0.5 µm.

21. Process according to any one of the claims 1 to 20, wherein said metal M, other than titanium, is chosen from among hafnium, zirconium, vanadium, niobium, tantalum, boron and aluminium.

22. Process according to any one of the claims 1 to 21, **characterized in that** before or after the deposition operation, a thermochemical treatment also takes place in the same enclosure.

23. Process according to claim 22, **characterized in that** said thermochemical treatment is chosen from among thermal and chemical nitriding and carburizing.

24. Process according to claim 11, wherein deposition takes place of a final protective layer based on oxide of the metal M, other than titanium, by introducing gaseous carbon dioxide into the reaction enclosure at the end of the process.

## Patentansprüche

1. Verfahren zur Herstellung einer Beschichtung eines Substrat, die wenigstens eine Schicht umfasst, die ausgewählt wird unter den durch Titannitrid TiN gebildeten Schichten, den durch Titancarbonitrid TiCN gebildeten Schichten, den durch Titannitrid und einem anderen Metall M gebildeten Ti₁₋ₓMₓNC-Schichten und den durch Titancarbonitrid und einem anderen Metall M gebildeten Ti₁₋ₓMₓNC-Schichten, bei dem die genannte Beschichtung kontinuierlich und in einer einzigen Operation mittels Plasma-unterstützter chemischer Gasphasenabscheidung (PACVD) aus einer gasförmigen Mischung erzeugt wird, die ein Reduktionsgas, Wasserstoff, eventuell einen Kohlenwasserstoff umfasst, und - als Zwischenstoffe der Titanchloride und eventuell eines anderen Metalls M - Zwischenstoffe in situ hergestellt werden, indem man Titantetrachlorid über eine Charge oder ein Target aus Festkörpermetall M strömen lässt.

2. Verfahren nach Anspruch 1, bei dem man vor und/oder während der Operation der PACVD-Abscheidung die Art und/oder die Zusammensetzung von der oder von jeder abgeschiedenen Schicht sofort anpasst, indem man einen oder mehrere Operationsparameter des Verfahrens variiert bzw. ändert.

3. Verfahren nach Anspruch 2, bei dem man die Art und/oder die Zusammensetzung von der oder von jeder abgeschiedenen Schicht anpasst, indem man das Reduktionsgas/Wasserstoff-Molverhältnis in der gasförmigen Mischung und/oder die Plasma-Leistung modifiziert.

4. Verfahren nach Anspruch 1, bei dem das Reduktionsgas Ammoniak NH₃ ist.

5. Verfahren nach Anspruch 1, bei dem das Reduktionsgas Stickstoff ist.

6. Verfahren nach Anspruch 1, bei dem das Reduktionsgas/Wasserstoff-Molverhältnis in der gasförmigen Mischung 0,01 bis 1 beträgt.

7. Verfahren nach einem der Ansprüche 1 bis 6, bei dem die Plasma-Leistung 0,0025 bis 0,025 W/cm³ beträgt.

8. Verfahren nach einem der Ansprüche 1 bis 7, bei dem in Bezug auf das TiCl₄ das andere Metall M als das Titan überschüssig ist.

9. Verfahren nach Anspruch 1, bei dem der genannte gasförmige Kohlenwasserstoff ausgewählt wird unter den 1 C- bis 3C-Alkanen wie etwa Methan.

10. Verfahren nach Anspruch 1, bei dem das Plasma erzeugt wird durch eine elektrische Impulsgleichstrom-Entladung ("pulsed d.c. PACVD").

11. Verfahren nach Anspruch 1, bei dem das Plasma erzeugt wird durch eine elektrische Radiofrequenz-Wechselstrom-Entladung ("r.f. PACVD").

12. Verfahren nach Anspruch 11, bei dem die genannte Radiofrequenz sich innerhalb eines Niederfrequenzbereichs von 50 kHz bis 460 kHz befindet.

13. Verfahren nach Anspruch 11, bei dem die genannte Radiofrequenz sich im Hochfrequenzbereich befindet und zum Beispiel 13,56 MHz beträgt.

14. Verfahren nach einem der Ansprüche 1 bis 13, bei dem der Druck 50 bis 500 Pa beträgt.

15. Verfahren nach einem der Ansprüche 1 bis 14, bei dem das zu beschichtende Substrat auf eine Temperatur von 500 K bis 1200 K gebracht wird,

16. Verfahren nach einem der Ansprüche 1 bis 15, bei dem die genannte Schicht eine Dicke von 0,01 bis 50 µm hat.

17. Verfahren nach Anspruch 16, bei dem die genannte Beschichtung eine einzige Schicht umfasst.

18. Verfahren nach einem der Ansprüche 1 bis 16, bei dem die genannte Beschichtung eine Multischicht-Beschichtung ist, die 2 bis 100 Schichten umfasst.

19. Verfahren nach Anspruch 18, bei dem die genannte Beschichtung eine Gesamtdicke von 1 bis 50 µm hat.

20. Verfahren nach einem der Ansprüche 18 und 19, bei dem jede Schicht eine Dicke von 0,1 µm bis 0,5 µm hat.

21. Verfahren nach einem der Ansprüche 1 bis 20, bei dem das genannte andere Metall M als das Titan ausgewählt wird unter Hafnium, Zirkonium, Vanadium, Niobium, Tantal, Bor und Aluminium.

22. Verfahren nach einem der Ansprüche 1 bis 21,
**dadurch gekennzeichnet,**
**dass** man vor oder nach der Abscheidungsoperation außerdem eine thermochemische Behandlung in demselben Behälter durchführt.

23. Verfahren nach Anspruch 22, **dadurch gekennzeichnet, dass** die genannte thermochemische Behandlung ausgewählt wird zwischen den thermischen oder chemischen Nitrierungen und den Karburierungen.

24. Verfahren nach Anspruch 11, **dadurch gekennzeichnet**, bei dem man eine finale Schutzschicht auf Basis des Oxids des anderen Metalls M als des Titans erzeugt, indem man am Ende des Verfahrens in den Reaktionsbehälter gasförmiges Kohlendioxid einspeist.
